# EUROPÄISCHE PATENTSCHRIFT

(11) **EP 1 217 730 B1**
(45) Veröffentlichungstag und Bekanntmachung des Hinweises auf die Patenterteilung: **20.06.2012**
(21) Anmeldenummer: 01123105.7
(22) Anmeldetag: 27.09.2001
(51) Int. Cl.: H03G 3/34, H04L 27/14, H04B 1/10

(54) **Verfahren zur Unterdrückung von Störspitzen in einem Nutzsignal**
Method for suppressing noise peaks in a wanted signal
Procédé d'élimination de parasites dans un signal utile

(30) Priorität: 22.12.2000 DE 10064493
(43) Veröffentlichungstag der Anmeldung: 26.06.2002
(73) Patentinhaber: ROBERT BOSCH GMBH, 70442 Stuttgart (DE)
(72) Erfinder: Nyenhuis, Detlev, 31079 Sibbesse (DE)

(56) Entgegenhaltungen:
- EP-A- 0 283 299
- US-A- 4 893 347
- US-A- 5 463 662

## Beschreibung

### Stand der Technik

Die Erfindung geht von einem Verfahren zur Unterdrückung von Störspitzen in einem Nutzsignal, das durch digitale Demodulation aus einem frequenz- oder phasenmodulierten Empfangssignal gewonnen wird, wobei im Falle einer erkannten Störspitze das Nutzsignal gedämpft wird, nach der Gattung des unabhängigen Verfahrensanspruchs aus.

Es sind elektronische Geräte zur Auswertung von durch digitale Demodulation aus einem frequenzmodulierten Empfangssignal gewonnenen Nutzsignalen in Form von Autoradiogeräten mit digitalem Rundfunkempfänger, wie beispielsweise im Prospekt "Mobile Kommunikationen 2000. www.blaupunkt.de." der Blaupunkt-Werke GmbH, Hildesheim, DE, beschrieben, bekannt. Solche Geräte verfügen über einen sogenannten DigiCeiver, wobei es sich laut der im o. g. Prospekt angegebenen Definition um ein in Digitaltechnik ausgeführtes Empfangsteil, das ein empfangenes Rundfunksignal vom Vorstufenausgang ab digital verarbeitet, handelt.

Es sind ferner Verfahren zur digitalen Demodulation von frequenzmodulierten (FM-)Signalen bekannt, die bei sehr geringer Empfangsfeldstärke eines empfangenen FM-Rundfunksignals unterhalb einer sogenannten FM-Schwelle Probleme aufweisen. Die FM-Schwelle ist dabei als Empfangsfeldstärke definiert, unterhalb derer das Rauschsignal ungefähr die Amplitude des aus dem empfangenen Rundfunksignal abgeleiteten zwischenfrequenten (ZF-) Nutzsignals aufweist. Bei solchermaßen schwach empfangenen Rundfunksignalen kommt es zu Phasensprüngen, die dann im durch Demodulation des ZF-Signals erhaltenen Nutzsignal zu Störspitzen und damit zu lautstarken Störungen in einem im Nutzsignal enthaltenen wiederzugebenden Audiosignal führen.

In US 5463662 ist ein ähnliches Verfahren beschreiben.

### Vorteile der Erfindung

Das erfindungsgemäße Verfahren zur Unterdrückung von Störspitzen in einem Nutzsignal, das durch digitale Demodulation aus einem frequenz- oder phasenmodulierten Empfangssingal gewonnen wird, wobei im Falle einer erkannten Störspitze das Nutzsignal gedämpft wird, mit den Merkmalen des unabhängigen Patentanspruchs hat den Vorteil, beim Stand der Technik beschriebene Störspitzen in einem durch digitale Demodulation aus einem frequenz- oder phasenmodulierten Empfangssignal gewonnenen Nutzsignal zuverlässig zu erkennen und wirkungsvoll zu unterdrücken. Damit werden durch die genannten Störspitzen verursachte Knack-Geräusche in einem Audiosignal, das in einem FM-Rundfunksignal beziehungsweise dem durch Demodulation daraus gewonnenen Nutzsignal enthalten ist, wirkungsvoll vermieden.

Dies wird dadurch erreicht, dass ein einen Momentanwert des Nutzsignals repräsentierender Momentanvergleichswert mit einem einen Mittelwert des Nutzsignals repräsentierenden Vergleichsmittelwert verglichen wird, dass ein die Empfangsfeldstärke des Empfangssignals repräsentierender Feldstärkevergleichswert mit einem Feldstärkereferenzwert verglichen wird, und dass eine Störspitze dann erkannt wird, wenn der Momentanvergleichswert größer als der Vergleichsmittelwert ist und der Feldstärkevergleichswert kleiner als der Feldstärkereferenzwert ist.

Vorteilhafte Ausführungsformen und Weiterbildungen der Erfindung sind in den abhängigen Patentansprüchen angegeben.

So ist gemäß einer vorteilhaften Ausführungsform der Erfindung vorgesehen, dass der Momentanvergleichswert der Momentanamplitude des gleichgerichteten Nutzsignals entspricht.

Eine erste Gruppe vorteilhafter Ausführungsformen und Weiterbildungen richten sich auf die Mittelung zur Gewinnung des Vergleichsmittelwerts.

So ist es von besonderem Vorteil, wenn der Vergleichsmittelwert durch zeitliche Mittelung des Nutzsignals gewonnen wird. Gegenüber einem fest vorgegebenen Vergleichsmittelwert hat dies den Vorteil, daß als Referenz für den Vergleich des Momentanvergleichswerts stets ein dem tatsächlichen mittleren Signalpegel entsprechender Wert zur Verfügung steht. Die Störerkennung funktioniert somit unabhängig von einem Pegel des Nutzsignals sowohl für geringe, wie auch hohe Nutzsignalpegel gleichermaßen. Weiterhin hat die zeitliche Mittelung den Vorteil, gegenüber kurzzeitigen Schwankungen des Nutzsignals, insbesondere aber den zu detektierenden Störspitzen unempfindlich zu sein.

Eine weitere besonders vorteilhafte Ausführungsform der Erfindung richtet sich darauf, dass die Mittelung des Nutzsignals zur Bildung des Vergleichsmittelwerts nichtlinear ist. Eine solche nichtlineare Mittelwertbildung ist gegenüber Störspitzen im Nutzsignal besonders unempfindlich. Dies wird bei einer vorteilhaften Ausführungsform eines nach dem erfindungsgemäßen Verfahren funktionierenden elektronischen Geräts durch einen Quantisierer erreicht. Demzufolge fließen Sprünge in der Nutzsignalamplitude nur in begrenztem Maß in die Mittelwertberechnung ein.

Weiterhin ist es auch von besonderem Vorteil, wenn die Zeitkonstante der Mittelwertberechnung über einen dafür einzustellenden Parameter an eine Dynamik des Nutzsignal oder eine Dynamik üblicherweise beobachteter Störspitzen oder Störungen anpaßbar ist. Damit kann weiterhin die Unempfindlichkeit der Mittelwertberechnung gegenüber den zu unterdrückenden Störspitzen oder Störungen erhöht, gleichzeitig aber auch eine ausreichende Reaktionsfähigkeit des Verfahrens auf Störspitzen erreicht werden.

Eine weitere Gruppe vorteilhafter Ausführungsformen der Erfindung richtet sich auf eine geeignete Bemessung des Vergleichsmittelwertes.

So ist es von Vorteil, dass der Vergleichsmittelwert durch Skalierung des zeitlichen Mittels des Nutzsignals, also Multiplikation des zeitlichen Mittels des Nutzsignals mit einem vorgegebenen Faktor, gewonnen wird. Damit wird vermieden, daß die erfindungsgemäße Störerkennung bereits auf geringfügige Schwankungen der Nutzsignalamplitude, wie diese beispielweise im Falle von Audiosignalen häufig zu beobachten sind, anspricht. Die Skalierung ermöglicht mithin die Vorgabe eines Sicherheitsabstandes zwischen Ansprechschwelle der Störerkennung und Nutzsignalpegel.

Weiter ist es von Vorteil, wenn der Vergleichsmittelwert durch Überlagerung eines einstellbaren Offset aus dem Nutzsignalmittelwert oder einem daraus durch Multiplikation mit einem Faktor gewonnenen Signal erzeugt wird. Dies erweist sich inbesondere im Bereich sehr kleiner Signalamplituden von Vorteil, da ohne den zusätzlichen Offset bereits geringste Schwankungen der Signalamplitude als Störungen erkannt würden. Die Vorgabe des Offset ermöglicht auch hier einen Sicherheitsabstand, so daß eine Mindestdynamik des Nutzsignals ohne Fehlinterpretation als Störung ermöglicht wird.

Eine weitere Gruppe von Ausführungsformen richtet sich auf die Art der Dämpfung des Nutzsignals im Falle einer erkannten Störspitze.

So richtet sich eine vorteilhafte Ausgestaltung der Erfindung richtet darauf, dass das Nutzsignal im Falle einer erkannten Störspitze oder Störung auf einen vorgegebenen Wert abgesenkt wird. Eine besonders einfache und damit auch schaltungs- beziehungsweise rechentechnisch ausführbare Ausführungsform richtet sich darauf, dass das Nutzsignal im Falle einer erkannten Störung vollständig unterdrückt wird.

Eine alternative Ausführungsform richtet sich hingegen darauf, dass das Nutzsignal im Falle einer erkannten Störung um einen vorgegebenen Wert abgesenkt wird. Dies führt im Falle eines MPX-Signals und eines darin enthaltenen Audiosignals nach derzeitiger Einschätzung zu einer besonders wirkungsvollen, weil weitestgehend unhörbaren, Unterdrückung einer Störspitze oder Störung im Nutzsignal.

Weitere Ausgestaltungen der Erfindung richten sich auf die genannten Vergleichsoperationen.

Eine vorteilhafte Ausgestaltung der Erfindung richtet sich darauf, dass der Vergleich des Momentanvergleichswerts mit dem Vergleichsmittelwert nur dann durchgeführt, wenn festgestellt wird, dass der Feldstärkevergleichswert kleiner als der Feldstärkereferenzwert ist. Hierdurch kann eine unerwünschte Trägheit des Systems vermieden werden, da auch Signale mit hoher Dynamik, die andernfalls möglicherweise als Störspitzen detektiert würden, weitergeleitet und somit durch nachfolgenden Stufen weiterverarbeitet werden können.

Weiterhin hat diese Weiterbildung den Vorteil, dass der rechentechnische Aufwand zum Vergleich des Momentanvergleichswerts mit dem Vergleichsmittelwert nur dann aufgebracht werden muss, wenn mit hoher Wahrscheinlichkeit mit Störspitzen zu rechnen ist, was erwartungsgemäß nur dann der Fall, wenn der Feldstärkevergleichswert kleiner als der Feldstärkereferenzwert ist.

Das erfindungsgemäße Verfahren, hat weiterhin den besonderen Vorteil einer geringen Reaktionszeit auf das Auftreten von Störspitzen und damit einer Dämpfung oder Unterdrückung der Werte des Nutzsignals, die als Störspitze oder als Störung erkannt werden.

### Zeichnungen

Ausführungsbeispiele der Erfindung sind in den Figuren dargestellt und werden nachfolgend näher erläutert.

Es zeigen
Figur 1 ein Blockschaltbild des erfindungswesentlichen Teils eines nach dem erfindungsgemäßen Verfahren funktionierenden Rundfunkempfängers zum Empfang von FM-Rundfunksignalen und
Figur 2 ein Blockschaltbild zur Realisierung der erfindungsgemäßen Störerkennung.

### Beschreibung der Ausführungsbeispiele

Das erfindungsgemäße Verfahren wird nachfolgend am Beispiel eines zum Empfang von FM-Rundfunksignalen ausgebildeten Rundfunkempfängers für mobilen Einsatz, insbesondere eines Autoradiogeräts, erläutert. Dies bedeutet jedoch keinerlei Einschränkung hinsichtlich der Anwendbarkeit des Verfahrens, das prinzipiell auf sämtliche, über stör- oder verlustbehaftete Kanäle übertragene FM-Empfangssignale anwendbar ist.

Der Rundfunkempfänger 1 umfaßt eine an ein digitales Empfangsteil 12 angeschlossene Empfangsantenne 11, an der ein Gemisch aus frequenzmodulierten Rundfunkfrequenzen ansteht. Das Empfangsteil 12 des Rundfunkempfängers wählt nach Maßgabe eines von einer Steuerung 16 des Rundfunkempfängers bestimmten Abstimmsignals 123 aus dem am Antenneneingang 11 anstehenden Rundfunkfrequenzgemisch eine bestimmte Rundfunkfrequenz aus und mischt diese in eine Zwischenfrequenz- (ZF-) Ebene hinab. Durch digitale Demodulation des aus dem empfangenen Rundfunksignal gewonnen ZF-Signals wird im Empfangsteil 12 ein in digitaler Form vorliegendes Stereo-Multiplexsignal (MPX) gewonnen, welches den Modulationsgehalt des FM-modulierten Rundfunksignals darstellt. Das digitale MPX-Signal ist an einem ersten Ausgang 121 des digitalen Empfangsteils 12 abnehmbar.

Der Pegel des durch Herabmischung in die ZF-Ebene gebildeten ZF-Signals ist ein Maß für die Empfangsfeldstärke des am Antenneneingang 11 anstehenden, nach Maßgabe des Abstimmsignals 123 ausgewählten Rundfunksignals. Ein aus dem ZF-Pegel abgeleitetes, die Empfangsfeldstärke des empfangenen Rundfunksignals anzeigendes Feldstärkesignal ist an einem zweiten Ausgang 122 des digitalen Empfangsteils 12 abnehmbar. Dieses wird vorzugsweise durch zeitliche Mittelung über den Betrag des ZF-Signals gebildet.

Sowohl das am ersten Ausgang 121 des Empfangsteils 12 anstehende MPX-Signal, als auch das am zweiten Ausgang 122 des Empfangsteils 12 anstehende Feldstärkesignal sind einer Störerkennung 15 zugeführt, die bei dem in der Figur dargestellten Ausführungsbeispiel als Bestandteil der Gerätesteuerung 16 ausgeführt ist.

Die Gerätesteuerung 16 dient der Steuerung der diversen Funktionen des Rundfunkempfängers 1 und ist vorzugsweise in Form eines Mikroprozessors und eines durch den Mikroprozessor abzuarbeitenden Betriebsprogramms realisiert.

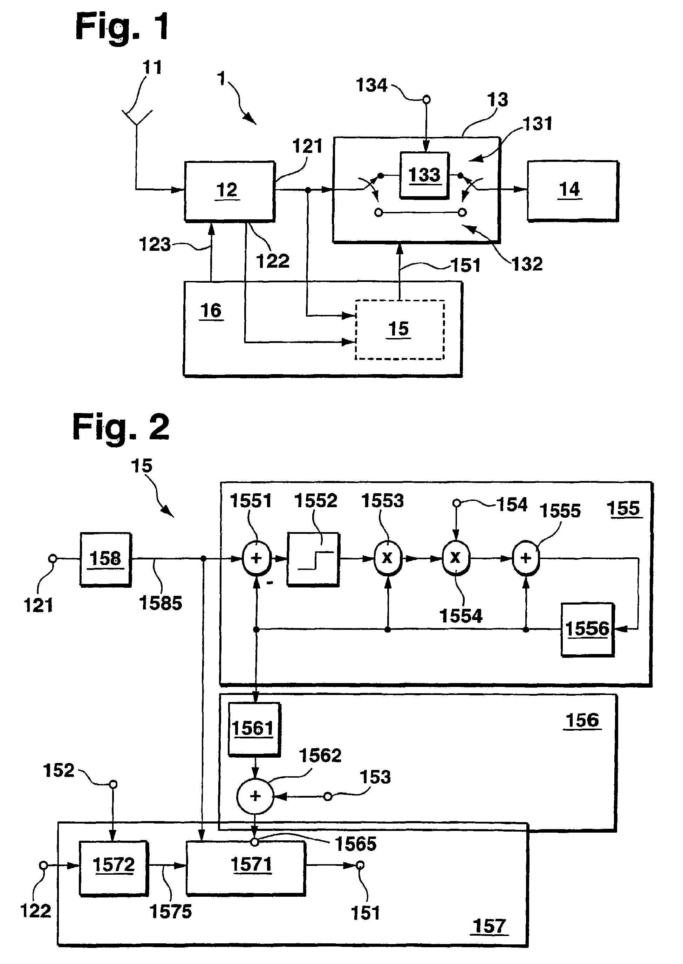

Bei einer bevorzugten Ausführungsform der Erfindung kann die Störerkennung 15 demgegenüber als eigene Baugruppe oder vorzugsweise als Bestandteil eines digitalen Demodulators, der gemäß Figur 1 Bestandteil des Empfangsteils 12 ist, ausgeführt sein.

Am Ausgang der Störerkennung 15 ist im Falle einer erkannten Störspitze oder Störung im durch Demodulation des empfangenen FM-Rundfunksignals gewonnen Nutzsignal, hier also dem MPX-Signal, ein entsprechendes, eine Störung anzeigendes Störsignal 151 abnehmbar. Dieses ist einem Steuereingang einer steuerbaren Dämpfungsvorrichtung 13 zur Steuerung derselben zugeführt. Einem Nutzsignaleingang der Dämpfungseinrichtung 13 ist das Nutzsignal, hier also das MPX-Signal, zugeführt. Im Falle eines das Vorliegen einer Störung anzeigenden Störsignals 151 leitet die Dämpfungseinrichtung 13 das an ihrem Nutzsignaleingang anstehende Nutzsignal über ein in einem ersten Signalpfad 131 enthaltenes Dämpfungsglied 133 an nachfolgende Weiterverarbeigungsstufen 14 des erfindungsgemäßen Rundfunkempfängers weiter. Weiterhin ist die Dämpfungseinrichtung 13 derart ausgelegt, dass sie im Falle eines keine Störung anzeigenden Störungssignals 151 das an ihrem Eingang anstehende Nutzsignal unbeeinflußt über einen zweiten Signalpfad 132 an die Weiterverarbeitungsstufen 14 weiterleitet.

Das Dämpfungsglied 133 der Dämpfungseinrichtung 13 kann vorteilhafterweise derart ausgeführt sein, dass es eine konstante Dämpfung des ihm zugeführten Nutz- beziehungsweise MPX-Signals bewirkt. Alternativ kann das Dämpfungsglied 133 im ersten Signalpfad 131 der Dämpfungseinrichtung 13 aber auch derart ausgeführt sein, dass sein Dämpfungsfaktor nach Maßgabe eines entsprechenden Dämpfungsfaktorsteuersignals 134 vorgebbar ist. Vorzugsweise wird das Dämpfungsfaktorsteuersignal 134 durch die Steuerung 16 derart bestimmt, daß das Dämpfungsglied 133 eine vorgegebene Dämpfung, also eine Bewertung des Nutzsignals mit einem Faktor zwischen den Extremwerten "0" und "1", bewirkt.

Gemäss einer besonders einfachen Ausführungsform der Erfindung kann das Dämpfungsglied 133 im ersten Signalpfad 131 der Dämpfungseinrichtung 13 demgegenüber auch entfallen, in diesem Falle bewirkt die Dämpfungseinrichtung 13 im Falle einer erkannten Störung und eines entsprechenden, eine Störung anzeigenden Störsignals 151 eine vollständige Unterdrückung des am Eingang der Dämpfungseinrichtung 13 anliegenden Nutzsignals. Die Wiedergabe eines im empfangenen Rundfunksignal enthaltenen Audiosignals wird dann für die Dauer einer erkannten Störspitze gemutet, also stumm geschaltet.

Die Weiterverarbeitungsstufen 14 des Rundfunkempfängers 1 bestehen beispielsweise in einer Wiedergabevorrichtung zur akustischen Wiedergabe eines im MPX-Signal enthaltenen Audiosignals. Dazu verfügen die Weiterverarbeitungsstufen 14 in an sich bekannter Weise über einen Stereo-Decoder zur Bildung der Audiosignale eines linken und eines rechten Stereo-Kanals aus dem MPX-Signal, des weiteren über eine Lautstärke- und gegebenenfalls Klangbeeinflussungseinrichtung, eine abschließende NF-Stufe zur Verstärkung der Audiosignale des linken und des rechten Stereokanals und schließlich Lautsprecher zur Ausgabe der verstärkten Audiosignale.

Alternativ oder ergänzend können die Weiterverarbeitungsstufen 14 auch beispielsweise einen RDS-Demodulator und eine entsprechende Auswertungseinrichtung, beispielsweise für mittels RDS nach dem TMC-Standard übertragene, codierte Verkehrsmeldungen, umfassen.

Aufbau und Funktionsweise der Störerkennung 15 zur Bildung eines Störsignals 151, das eine Störspitze im aus dem empfangenen Rundfunksignal gebildeten Nutzsignal anzeigt, wird nachfolgend anhand des in Figur 2 dargestellten Blockschaltbilds erläutert.

Die Störerkennung 15 umfaßt im Wesentlichen die Funktionsblöcke Mittelwertberechnung 155, Skalierung 156, Komparatoren 157 und Betragsbildung 158.

Wie bereits erwähnt, sind der Störerkennung 15 sowohl das am ersten Ausgang des Empfangsteils 12 anstehende, aus dem empfangenen Rundfunksignal durch digitale Demodulation gewonnene Nutzsigna, hier also das MPX-Signal, als auch das die Empfangsfeldstärke des empfangenen Rundfunksignals repräsentierende Feldstärkesignal zugeführt. Durch den Betragsbildner 158 wird ein einen Momentanwert des Nutzsignals 121 repräsentierender Momentanvergleichswert 1585 gebildet. Dieser ist sowohl der Mittelwertberechnung 155, als auch den Komparatoren 157 zugeführt.

Die Mittelwertbildung 155 bestimmt aus dem ihr zugeführten Nutzsignalbetrag ein Mittelwertsignal, das entweder selbst als Vergleichsmittelwert für die beschriebenen Vergleichsoperationen herangezogen wird, oder aus dem durch Skalierung 156 der Vergleichsmittelwert bestimmt wird.

Beim in Figur 2 dargestellten Ausführungsbeispiel der Mittelwertbildung 155 umfaßt diese ein erstes Summierglied 1551, dessen erstem Eingang der oben beschriebene Momentanvergleichswert zugeführt ist, und auf dessen zweiten Eingang der durch die Mittelwertbildung 155 gebildete Mittelwert des Nutzsignals, mit negativem Vorzeichen bewertet, rückgekoppelt ist. Das auf diese Weise mittels des ersten Summiergliedes 1551 gebildete Differenzsignal ist einem Quantisierer 1552 zugeführt, der das Differenzsignal in ein zweiwertiges Signal umsetzt.

Der Quantisierer 1552 als Teil der Mittelwertbildung 155 bewirkt eine weitgehende Unempfindlichkeit der Mittelwertbildung, in der sich ansonsten Störspitzen in Form einer störenden Beeinflussung des Mittelwerts bemerkbar machen würden, gegenüber Störspitzen im Nutzsignal.

Das am Ausgang des Quantisierers 1552 anstehende zweiwertige Signal ist einem ersten Multiplizierer 1553 zugeführt, dem weiterhin auch der rückgekoppelte Mittelwert des Nutzsignals zugeführt ist. Das sich durch Multiplikation 1553 des quantisierten Signals mit dem rückgekoppelten Mittelwertsignal ergebende Produktsignal ist einem zweiten Multiplizierer 1554 zugeführt, dem weiterhin ein geeignet einstellbarer steuerbarer Faktor 154 zugeführt ist. Der steuerbare Faktor 154 dient der Einstellung der Trägheit beziehungsweise der Reaktionsfähigkeit der Mittelwertberechnung 155.

Das am Ausgang des zweiten Multiplizierers 1554 anstehende Produktsignal ist einem zweiten Addierer 1555 zugeführt, auf dessen zweiten Eingang wiederum der Mittelwert des Nutzsignals, hier mit positivem Vorzeichen bewertet, rückgekoppelt ist. Das Mittelwertsignal ergibt sich aus dem Ausgangssignal des zweiten Addierers 1555 durch Verzögerung mittels eines Verzögerungsgliedes 1556 um eine Abtastperiode.

Das am Ausgang des Zeitgliedes 1556 abnehmbare, den Mittelwert des Nutzsignals repräsentierende Mittelwertsignal ist der Skalierung 156 zugeführt. In einer ersten Stufe 1561 der Skalierung erfolgt eine Multiplikation des Mittelwertsignals mit einem konstanten Faktor zur Skalierung des Signals. Weiterhin umfaßt die Skalierung 156 einen dritten Addierer 1562, in dem zu dem am Ausgang der ersten Stufe 1561 anstehenden, aus dem Mittelwertsignal abgeleiteten Signal ein Offset 153, hier ein konstanter Wert, hinzuaddiert wird. Am Ausgang des dritten Addierers 1562 steht der Vergleichsmittelwert an, der einen Mittelwert des Nutzsignals repräsentiert. Dieser ist nach Maßgabe des Offsets 153 und Einstellung des Skalierungsfaktors in der ersten Stufe 1561 der Skalierung geeignet beeinflußbar.

Die Bewertung des Mittelwertsignals mit Skalierungsfaktor und additivem Offset ermöglicht die Vorgabe eines Sicherheitsabstandes zwischen Nutzsignalpegel und Vergleichsmittelwert derart, daß eine Mindestdynamik des Nutzsignals zugelassen wird, ohne daß diese als Störspitze fehlinterpretiert wird. Demgemäß bemessen sich Skalierungsfaktor nach der maximal zulässigen Nutzsignaldynamik und der Trägheit der Mittelwertbildung.

Der am Ausgang der Skalierung 156 abnehmbare Vergleichsmittelwert 1565 und der Momentanvergleichswert 1585 sind der Komparatorenschaltung 157 zugeführt. Diese dient der Durchführung der erfindungsgemäßen Vergleichsoperationen zur Detektion einer Störspitze im Nutzsignal und der Erzeugung des Störsignals 151 im Falle einer erkannten Störspitze. Es wird dabei davon ausgegangen, daß eine Störspitze im Nutzsignal mit hoher Wahrscheinlichkeit nur im Falle schwachen Empfangs vorliegen kann, also nur dann, wenn die Empfangsfeldstärke im Bereich der FM-Schwelle liegt. Daher sind der Komparatorenschaltung weiterhin das Feldstärkesignal als Feldstärkevergleichswert und eine Feldstärkereferenzwert 152 zu Vergleichszwecken zugeführt.

Die erste Komparatorstufe 1571 der Komparatorenschaltung 157 vergleicht den einen Momentanwert des Nutzsignals repräsentierenden Momentanvergleichswert 1585 mit dem den Mittelwert des Nutzsignals repräsentierenden Vergleichsmittelwert 1565 und erzeugt ein eine Störspitze anzeigendes Störsignal 151, sofern die Ausgabe eines eine Störung anzeigenden Störsignal 151 nach Maßgabe eines durch eine zweite Komparatorstufe 1572 gebildeten Freischaltsignals 1575 freigeschaltet wird.

Zur Einsparung von Rechenaufwand kann alternativ auch vorgesehen sein, dass auch die Vergleichsoperation in der ersten Komparatorstufe 1571 erst dann durchgeführt wird, wenn diese durch ein Freischaltsignal 1575 der zweiten Komparatorstufe 1572 freigeschaltet wird.

Der zweiten Komparatorstufe 1572 sind zum einen das am zweiten Ausgang 122 des Empfangsteils 12 anstehende Feldstärkesignal als ein die Empfangsfeldstärke des Empfangssignals repräsentierender Feldstärkevergleichswert sowie ein Feldstärkereferenzwert 152 zugeführt. Der Feldstärkereferenzwert entspricht in einem ersten einfachen Ausführungsbeispiel der beim Stand der Technik erwähnten sogenannten FM-Schwelle.

In der zweiten Komparatorstufe 1572 wird der die Empfangsfeldstärke des Empfangssignals repräsentierende Feldstärkevergleichswert mit dem vorgegebenen Feldstärkereferenzwert 152 zur Bildung des Freigabesignals 1575 verglichen. Für den Fall, dass der Feldstärkevergleichswert kleiner als der Feldstärkereferenzwert 152 ist, wird das Freischaltsignal 1575 erzeugt und damit die Erzeugung eines eine Störung anzeigenden Störsignals freigeschaltet.

Das erfindungsgemäße Verfahren zur Unterdrückung von Störspitzen in einem Nutzsignal, das durch digitale Demodulation aus einem frequenz- oder phasenmodulierten Empfangssignal gewonnen wird, wobei im Falle einer erkannten Störspitze das Nutzsignal gedämpft wird, funktioniert also dergestalt, dass ein einen Momentanwert des Nutzsignals repräsentierender Momentanvergleichswert mit einem einen Mittelwert des Nutzsignals repräsentierenden Vergleichsmittelwert verglichen wird, das ein die Empfangsfeldstärke des Empfangssignals repräsentierender Feldstärkevergleichswert mit einem Feldstärkereferenzwert verglichen wird, und dass eine Störspitze dann erkannt wird, wenn der Momentanvergleichswert größer als der Vergleichsmittelwert ist und der Feldstärkevergleichswert kleiner als der Feldstärkereferenzwert ist.

## Patentansprüche

1. Verfahren zur Unterdrückung von Störspitzen in einem Nutzsignal (121), das durch digitale Demodulation aus einem frequenz- oder phasenmodulierten Empfangssignal gewonnen wird,
wobei im Falle einer erkannten Störspitze das Nutzsignal (121) gedämpft wird,
ein einen Momentanwert des Nutzsignals repräsentierender Momentanvergleichswert (1585) mit einem einen Mittelwert des Nutzsignals repräsentierenden Vergleichsmittelwert (1565) verglichen wird, **dadurch gekennzeichnet.**
**daß** ein die Empfangsfeldstärke des Empfangssignals repräsentierender Feldstärkevergleichswert (122) mit einem Feldstärkereferenzwert (152) verglichen wird,
und **daß** eine Störspitze dann erkannt wird, wenn der Momentanvergleichswert (1585) größer als der Vergleichsmittelwert (1565) ist und der Feldstärkevergleichswert (122) kleiner als der Feldstärkereferenzwert (152) ist.

2. Verfahren nach Anspruch 1, **dadurch gekennzeichnet, daß** der Momentanvergleichswert (1585) der Momentanamplitude des gleichgerichteten Nutzsignals (121) entspricht.

3. Verfahren nach Anspruch 1 oder 2, **dadurch gekennzeichnet, daß** der Vergleichsmittelwert (1565) durch zeitliche Mittelung (155) des Nutzsignals (121) gewonnen wird.

4. Verfahren nach Anspruch 3, **dadurch gekennzeichnet, daß** der Vergleichsmittelwert (1565) durch Multiplikation (1561) des zeitlichen Mittels des Nutzsignals mit einem vorgegebenen Faktor gewonnen wird.

5. Verfahren nach einem der Ansprüche 1 bis 4, **dadurch gekennzeichnet, daß** das Nutzsignal (121) im Falle einer erkannten Störung unterdrückt wird.

6. Verfahren nach einem der Ansprüche 1 bis 4, **dadurch gekennzeichnet, daß** das Nutzsignal (121) im Falle einer erkannten Störung um einen vorgegebenen Wert abgesenkt (133) wird.

7. Verfahren nach einem der vorhergehenden Ansprüche, **dadurch gekennzeichnet, daß** die Mittelung (155) des Nutzsignals (121) zur Bildung des Vergleichsmittelwerts (1565) nichtlinear ist.

8. Verfahren nach einem der vorhergehenden Ansprüche, **dadurch gekennzeichnet, daß** der Vergleich (1571) des Momentanvergleichswerts (1585) mit dem Vergleichsmittelwert (1565) nur dann durchgeführt wird, wenn festgestellt wird, daß der Feldstärkevergleichswert (122) kleiner als der Feldstärkereferenzwert (152) ist.

9. Verfahren nach einem der vorhergehenden Ansprüche, **dadurch gekennzeichnet, daß** die Werte des Nutzsignals (121) gedämpft (133) werden, die als Störspitze erkannt werden.

## Claims

1. Method for suppressing interference spikes in a wanted signal (121) obtained from a frequency-modulated or phase-modulated received signal by means of digital demodulation,
the wanted signal (121) being attenuated if an interference spike is detected,
an instantaneous comparison value (1585) which represents an instantaneous value of the wanted signal being compared with a comparison average value (1565) which represents an average value of the wanted signal, **characterized in that**
a field strength comparison value (122) which represents the reception field strength of the received signal is compared with a field strength reference value (152),
and **in that** an interference spike is detected when the instantaneous comparison value (1585) is greater than the comparison average value (1565) and the field strength comparison value (122) is less than the field strength reference value (152).

2. Method according to Claim 1, **characterized in that** the instantaneous comparison value (1585) corresponds to the instantaneous amplitude of the rectified wanted signal (121).

3. Method according to Claim 1 or 2, **characterized in that** the comparison average value (1565) is obtained by averaging (155) the wanted signal (121) over time.

4. Method according to Claim 3, **characterized in that** the comparison average value (1565) is obtained by multiplying (1561) the temporal average of the wanted signal by a predefined factor.

5. Method according to one of Claims 1 to 4, **characterized in that** the wanted signal (121) is suppressed if interference is detected.

6. Method according to one of Claims 1 to 4, **characterized in that** the wanted signal (121) is reduced (133) by a predefined value if interference is detected.

7. Method according to one of the preceding claims, **characterized in that** the averaging (155) of the wanted signal (121) to form the comparison average value (1565) is non-linear.

8. Method according to one of the preceding claims, **characterized in that** the instantaneous comparison value (1585) is compared (1571) with the comparison average value (1565) only when it is determined that the field strength comparison value (122) is less than the field strength reference value (152).

9. Method according to one of the preceding claims, **characterized in that** the values of the wanted signal (121) which are identified as the interference spike are attenuated (133).

## Revendications

1. Procédé d'élimination de pics parasites dans un signal utile (121) obtenu par démodulation numérique à partir d'un signal de réception modulé en fréquence ou en phase,
dans lequel le signal utile (121) est amorti dans le cas d'un pic parasite identifié,
on compare une valeur de comparaison momentanée (1585) représentant une valeur momentanée du signal utile avec une valeur moyenne de comparaison (1565) représentant une valeur moyenne du signal utile,
**caractérisé en ce qu'**on compare une valeur de comparaison de l'intensité du champ (122) représentant l'intensité du champ de réception du signal de réception avec une valeur de référence de l'intensité du champ (152),
et **en ce qu'**on identifie un pic parasite lorsque la valeur de comparaison momentanée (1585) est supérieure à la valeur moyenne de comparaison (1565) et que la valeur de comparaison de l'intensité du champ (122) est inférieure à la valeur de référence de l'intensité du champ (152).

2. Procédé selon la revendication 1, **caractérisé en ce que** la valeur de comparaison momentanée (1585) correspond à l'amplitude momentanée du signal utile (121) redressé.

3. Procédé selon la revendication 1 ou 2, **caractérisé en ce que** la valeur moyenne de comparaison (1565) est obtenue à partir de la moyenne temporelle (155) du signal utile (121).

4. Procédé selon la revendication 3, **caractérisé en ce que** la valeur moyenne de comparaison (1565) est obtenue par multiplication (1561) de la moyenne temporelle du signal utile avec un facteur prédéfini.

5. Procédé selon une des revendications 1 à 4, **caractérisé en ce que** le signal utile (121) est amorti dans le cas d'une perturbation identifiée.

6. Procédé selon une des revendications 1 à 4, **caractérisé en ce que** le signal utile (121) est abaissé d'une valeur prédéfinie (133) dans le cas d'une perturbation identifiée.

7. Procédé selon une des revendications précédentes, **caractérisé en ce que** la moyenne (155) du signal utile (121) pour la formation de la valeur moyenne de comparaison (1565) n'est pas linéaire.

8. Procédé selon une des revendications précédentes, **caractérisé en ce que** la comparaison (1571) de la valeur de comparaison momentanée (1585) avec la valeur moyenne de comparaison (1565) ne peut s'effectuer que lorsqu'on constate que la valeur de comparaison de l'intensité du champ (122) est inférieure à la valeur de référence de l'intensité du champ (152).

9. Procédé selon une des revendications précédentes, **caractérisé en ce que** les valeurs du signal utile (121) sont amorties (133) lorsque celles-ci sont identifiées comme pics parasites.
